# EUROPEAN PATENT SPECIFICATION

(11) **EP 0 630 113 B1**
(45) Date of publication and mention of the grant of the patent: **21.02.2001**
(21) Application number: 94201648.6
(22) Date of filing: 09.06.1994
(51) Int. Cl.: H03K 19/086

(54) **Integrated logic circuit with a single ended input logic gate**
Integrierte Logikschaltung mit Logikgattern mit einem einzigen Eingang
Circuit logique intégré avec portes logiques à entrée unique

(30) Priority: 16.06.1993 US 78719
(43) Date of publication of application: 21.12.1994
(73) Proprietor: Koninklijke Philips Electronics N.V., 5621 BA Eindhoven (NL)
(72) Inventor: Blauschild, Robert, NL-5656 AA Eindhoven (NL); Linebarger, Daniel, NL-5656 AA Eindhoven (NL)
(74) Representative: de Haas, Laurens Johan

(56) References cited:
- GB-A- 1 180 284
- US-A- 3 655 998
- US-A- 4 792 706

## Description

The invention relates to an integrated logic circuit with differential pairs of inputs for supplying complementary signals.

US patent No. 3,655,998 discloses a circuit with two input transistors, each having a control electrode coupled to a logic input from a different differential pair of inputs. Current from a current source is conducted either through the main current channel of a reference transistor or through main current channels of the input transistors, dependent on the logic signals at the control electrodes of the input transistors.

The complements of the signals used to control the control electrodes of the input transistors are used to control the voltage at the control electrode of the reference transistor. If any one of those logic signals makes the main current channel of the corresponding input transistor conduct, the voltage at the control electrode of the reference transistor is made to change in the opposite direction, so as to make the reference transistor less conductive.

This circuit is susceptible to noise when the voltage level at the inputs may vary, even if the logic state of the input signals (their difference) remains substantially the same.

Another circuit is known from US 4,877,977 and is shown in Figure 1. This circuit furthermore comprises a first resistor, the main current channel of the reference transistor being coupled to the supply voltage terminal via the first resistor. A node between this main current channel and the first resistor forms an output O of the circuit. The main current channels of the input transistors may be coupled to the supply voltage terminal via a second resistor, a node between these main current channels and the second resistor forming a further output, complementary to the first mentioned output.

In operation, when the voltage level at any one of the input connections A-D of this circuit becomes higher than that (V_{REF}) at the reference input REF, the voltage at the output O will become logic high. Hence the circuit may be used as an OR gate.

This circuit is susceptible to noise, especially from the voltage supply. In this case, although the logic state of the signals at the inputs A-D does not change, the voltage level at these inputs A-D may vary, for example when the voltage supply relative to which they are defined varies. This problem is aggravated in the case of high-speed logic in which small signal-swings are required.

As a more complicated alternative, use is made of Current-mode logic (CML) circuitry, such as shown in Colace, Electronic Product Design, January 1986, pages 43-46; Millman et al, "Pulse Digital, and Switching Waveforms", McGraw Hill Book Company, New York, 1965, pages 358-359; and Hamilton et al, "Basic Integrated Circuit Engineering", McGraw-Hill Book Company, New York, 1975, pages 492-497.

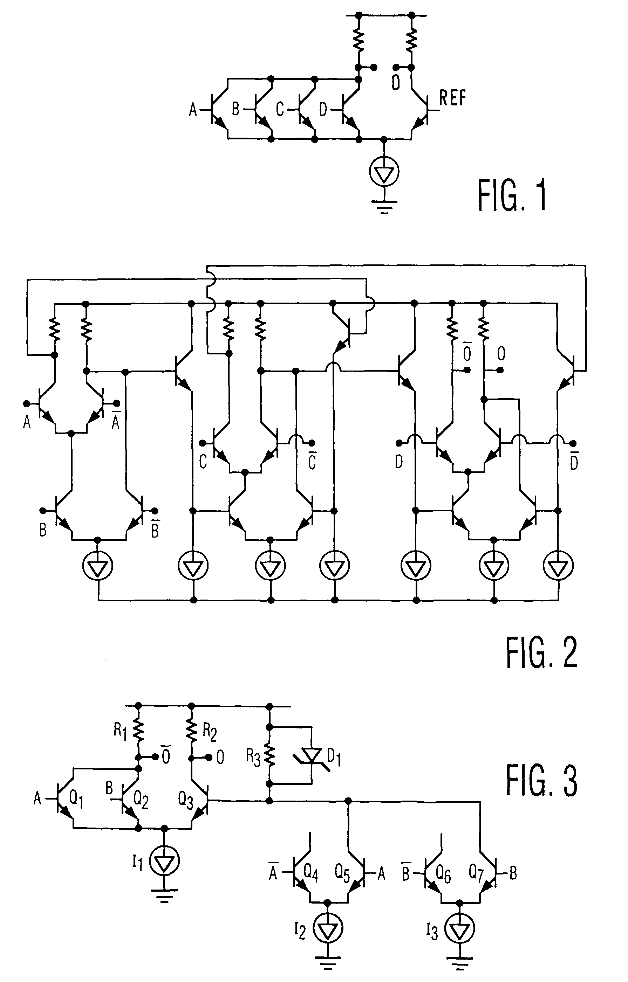

CML is shown in Figure 2. The multi-level CML of Fig. 2 uses differential signal paths and is therefore hardly susceptible to noise due to variations in the voltage supply. However, CML requires different logic levels for inputs A,A and B,B. Emitter followers can be used to translate from the top level to the bottom level as shown in Fig. 2.

The current-mode logic (CML), illustrated in Figure 2, offers high speed, but the required stacking of logic levels limits performance. This performance limitation is especially noticeable when a low voltage supply operation is necessary. For operation below two volts, for example, only two logic levels can be used. A four-input gate must be realized with a cascade of two-input gate leading to several gate delays and extra level shifts.

Amongst others, it is an object of the invention to provide new logic circuitry operating under a low voltage at high-speeds. In particular, the new logic circuitry of the present invention enables operation with a supply voltage of 1 volt, while retaining differential logic with fewer devices and lower operating current.

The logic integrated circuit according to the invention is characterized, in that at least one of the logic inputs is part of a differential pair of inputs, for supplying logically complementary signals to inputs of differential amplifier means, the differential amplifier means having an output coupled to a control electrode means of the reference transistor means, for driving a voltage level at said control electrode means to change in a direction opposite to a change in a voltage level at the logic input, as detected on the differential pair of inputs.

Thus, if the logic input is high, the voltage introduced at the control electrode of the reference transistor is reduced, which together makes the main current channel of the reference transistor non-conductive. If none of the inputs of the input transistors is high the voltage at the control electrode of the reference transistor will be high. Accordingly the main channel of the reference transistor will conduct. The change in voltage level at the control electrode of the reference transistor increases the margin for noise in the voltage level at the logic input. The change in the voltage at the control electrode of the reference transistor itself depends on a differential signal and is therefore hardly susceptible to noise.

Such new logic circuit operates at the high speed and low noise offered by CML circuitry, but with lower supply voltages. This structure enables a significantly increased speed advantage with less current and power-delay enhancement of multiple amounts.

An embodiment of the circuit according to the invention is characterized, in that each of the logic inputs is part of a respective differential pair of inputs, each for supplying logically complementary signals to inputs of respective differential amplifier means, outputs of the respective differential amplifier means being coupled to the control electrode means for driving the voltage level at said control electrode means to change in a direction opposite to a change in a voltage level at the logic input, as detected on the differential pair of inputs of that respective differential amplifier means. Thus the effect of noise on any of the inputs is reduced. For the case when several logic inputs to the input transistors are high, then the differential amplifier means drive the transistor to duplicate the logic function with a single one of the logic inputs being high. The only difference is that with several logic inputs being high the amount of change of the voltage level at the control electrode of the reference transistor is increased. Preferably, the reference transistor means consist of a reference transistor, whose control electrode forms the control electrode means. But in principle, noise reduction can also be obtained if the reference transistor is replaced by a plurality of reference transistors with their main current channels connected in parallel, each differential amplifier means driving the control electrode of a respective reference transistor. This requires more circuitry than when the amplifier means are all connected to the control electrode of the same transistor, but may cause fewer saturation problems.

Another embodiment of the invention is characterized, in that the differential amplifier means comprise a differential pair of transistors, with interconnected first main electrodes, the input connections of the differential pair of input connections being coupled to control electrodes of respective transistors of the differential pair of transistors, a second main electrode of the transistor of the differential pair of transistors which is coupled to the input of the single ended input logic gate being coupled to the control electrode means. The differential pair provides for a simple implementation of the differential amplifier means, which can operate at low supply voltages.

For the case when several of the inputs to the input transistors are high, the voltage of the control electrode of the reference transistor can be pulled low enough to saturate common ones of the differential pairs of transistors, so that the speed of the logic will deteriorate. If necessary to prevent saturation it is therefore preferred to provide for limiting means to limit the amount of change of the voltage level at the control electrode of the reference transistor. A Schottky diode is preferably used to limit the voltage level change.

Several single ended input logic gates with differential amplifier means connected thereto according to the invention may be cascaded in order to form more complicated logic circuits.

The invention will be described in more detail with reference to the drawing figures in which:
Figure 1 shows a prior art example of single-ended input logic which suffers from various problems;
Figure 2 represents a prior art showing of a two input gate CML;
Figure 3 is a circuit diagram of the new logic family of the present invention; and
Figure 4 is an expanded version of the new logic family of the present invention.

By way of example, the integrated circuit according to the invention will be illustrated as a new logic family implemented using bipolar transistors.

The new logic family of the present invention operates within a supply range of 1 V_{BE} plus 1 V_{CESAT}, allowing a single-cell battery application. In Figure 3 the minimum operating voltage for one input transistor, such as Q₁ receiving V_{CC}, is V_{BES} + V_{I2} (the voltage across current source I₂). The voltage across I₂ can be as low as V_{CESAT}, which may be approximately 0.1 to 0.2 volts. For V_{BE} equal to 0.6 to 0.7 volts, the minimum V_{CC} = 0.7 to 0.9 volts. This is only the lower supply limit, and the current can function up to the breakdown voltage of current sources I₁ and I₂.

The single-cell battery application can operate over the voltage 1.1 to 1.5 volts. The new-logic family of the present invention will operate properly with this supply, but the multilevel CML of the prior art will not.

In the structure of the present invention, as illustrated in Figure 3, differential logic is maintained, however, fewer devices and less operating current are required. This is distinctive from the cascaded CML of the prior art.

Figure 3 shows a schematic circuitry of a two-input version of the new logic. Transistors Q₁ Q₂, and Q₃ form a structure similar to the single-ended logic of Figure 1. In the new logic of Figure 3, however, the voltage at the base of transistor Q₃ is driven by differential pairs of transistors Q₄, Q₅ and Q₆, Q₇. This gate requires one more transistor than a two-input CML gate including second level buffers, but it can operate off of a lower supply voltage. The gate can be expanded to n inputs by adding input transistors in parallel with transistors Q₁ and Q₂ and adding differential pairs of transistors in parallel with transistor pair Q₆, Q₇.

In Figure 3, if the input A to transistor Q₁ is high and the input B to transistor Q₂ is low, then current will flow through transistors Q₅ and Q₇ of the respective differential pairs of transistors Q₄, Q₅ and Q₆, Q₇. The current through transistor Q₅ also flows through resistance R₃ to reduce the voltage at the base of transistor Q₃. Since the voltage at the base of the transistor Q₁, is high and the voltage at the bases of transistors Q₂ and Q₃ are low, then transistor Q₁ conducts and output O will be high and output O will be low. Outputs O and O are the logic gate outputs and can be connected to the inputs of the other gates in the desired logic design. This analysis is the same if input A is low and input B is high.

If neither input A nor input B is high, then current flows through transistors Q₄ and Q₆ and the voltage at the base of the transistor Q₃ will be high. Then, where transistors Q₁ and Q₂ are off and transistor Q₃ is conducting, the output O will be low and the output O will be high.

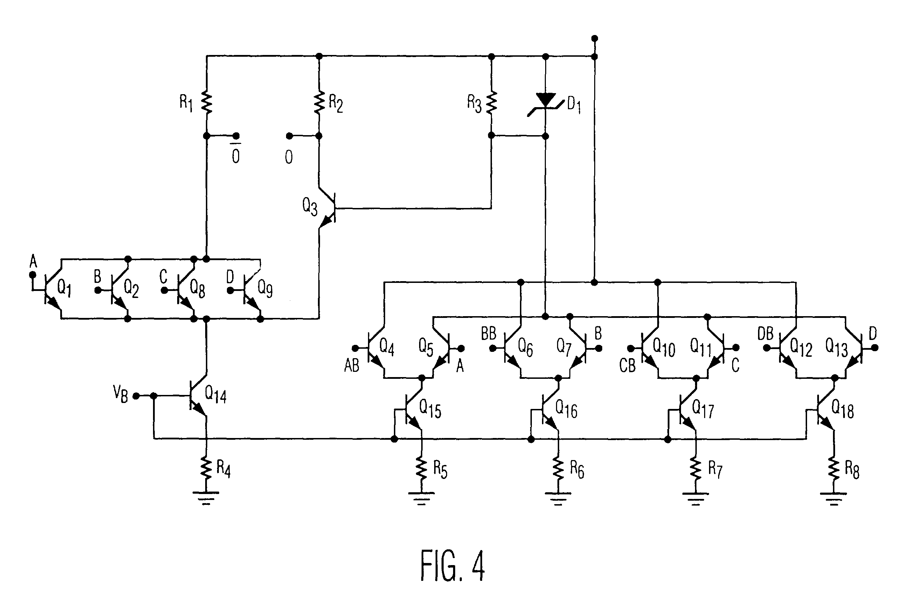

For both inputs A and B being high, then transistors Q₅ and Q₇ will conduct, duplicating the logic function that occurs with either input A or B being high. The only difference is that with both inputs being high, the voltage across R₃ is doubled. As more logic inputs are added, for example, inputs C and D in Figure 4, the voltage across R₃ increases with multiple high inputs. Eventually, the voltage at the base of transistor Q₃ can be pulled low enough to saturate transistors Q₅, Q₇, etc., and the speed of the logic will deteriorate. The Schottky diode D₁ may be used to limit voltage across R₃ to prevent saturation of the transistors.

The Schottky diode may also be included across the resistance R₃ to limit swing.

Figure 4 shows a schematic circuit diagram of the new logic family with a four-input gate. This circuit includes two additional input transistors Q₈, Q₉ together with additional differential pairs of transistors Q₁₀, Q₁₁ and Q₁₂, Q₁₃. These additional differential pairs of transistors are included with differential pairs of transistors Q₄, Q₅ and Q₆, Q₇ to drive transistor Q₃ and are coupled through transistor Q₃ to multiple inputs A, B, C, D for the respective transistors Q₁, Q₂, Q₈, Q₉.

Operation of this circuitry is similar to that of Figure 3, but shows an increased input and driving arrangement for the new logic family. Further, it shows that any number n of input transistors with a similar number n of differential driving transistors will operate the circuitry.

Ring oscillators may be used to compare the logic family performance of the prior art and the present invention. A nine-stage CML ring (representing three cascaded, four-input gates of the CML logic of Figure 2) may be compared to a seven stage ring of the new logic gate. The results are shown by comparison in the TABLE to provide a 36% speed advantage using 45% less current for the new logic. Since the CML gates of the prior art require a 2 volt supply versus a 1 volt supply for the new logic, a power-delay enhancement of 5.7 times is achieved. These advantages are achieved in addition to a more than 50% gate-area reduction due to fewer required devices in the new logic.

**TABLE 4 -**

| INPUT GATE COMPARISON | | | |
|---|---|---|---|
| ITEM | CML | NEW LOGIC | COMPARISON |
| No of Stages | 3 | 7 | |
| Osc. FREQUENCY | 130 MHz | 86 MHz | |
| Gate Delay | 1.29 nSec | 0.83 nSec | 36% less delay |
| CURRENT/GATE | 165µA | 90µA | 45% less current |
| Power-Delay Product | 4.24pJ | 0.745pJ | 5.7X |
| Supply voltage | 2V | 1V | |
| transistors/gate | 27 | 18 | |
| resistors/gate | 15 | 8 | |

Additional speed can be obtained by combining the devices with common collectors into single tubs to reduce capacitance. For typical bipolar processing, the term "tubs" are known as isolated epitaxial pockets or diffusion areas for semiconductor manufacture. For example, from Figure 3, the transistors Q1 and Q2 can be combined in semiconductor manufacture of the logic, as well as the transistors Q5 and Q7 and Q4 and Q6. The Schottky diode also can be included in the Q5, Q7 tub. If the diode is not required to prevent saturation due to smaller swings or lower common-mode inputs, for example, then its removal can improve speed in the circuitry.

Although the invention has been described in terms of bipolar transistors, it will be clear that it can also be realized using for example MOS FETs (more properly IGFETs).

## Claims

1. An integrated logic circuit with differential pairs of inputs for supplying complementary signals ((A,_A), (B,_B)), the circuit comprising
- a single ended input gate comprising
- a current source (I1);
- at least two input transistors (Q1, Q2), each having a control electrode coupled to a logic input from a respective one (A,B) of the pairs of inputs;
- a reference transistor (Q3), main current channels of the reference transistor and the input transistor being coupled in parallel with each other between the current source and a voltage supply terminal;
the circuit comprising a logic combination circuit (I2, I3, Q4, Q5, Q6, Q7, R3, D1) coupled to a control electrode of the reference transistor (Q3), for generating voltage level changes corresponding to a logic NOR of signals (A,B) at the logic inputs of the respective ones of the pairs of inputs and supplying said logic level changes to the control electrode of the reference transistor (Q3);
characterized in that the logic combination circuit comprises differential amplifiers (I2, Q4, Q5), (I3,Q6, Q7), each differential pair of inputs ((A,_A), (B,_B)) being coupled to a respective one of the amplifiers (I2, Q4, Q5), (I3,Q6, Q7), outputs of the differential amplifiers (I2, Q4, Q5), (I3,Q6, Q7) being coupled together to form said voltage level changes.

2. An integrated circuit according to Claim 1, characterized in that the differential amplifiers (I2, Q4, Q5), (I3,Q6, Q7) comprise a differential pair of transistors (Q4, Q5, Q6, Q7), with interconnected first main electrode, the input connections of the differential pair of input connections being coupled to control electrodes of respective transistors of the differential pair of transistors (Q4, Q5, Q6, Q7), a second main electrode of the transistor (Q5, Q7) of the differential pair of transistors which is coupled to the input (A, B) of the single ended input logic gate being coupled to the control electrode of the reference transistor (Q3).

3. An integrated logic circuit according to Claim 2, characterized in that it comprises limiting means (D1, R3), connected to the control electrode of the reference transistor (Q3), for limiting an amount of change of the voltage level at said control electrode so as to prevent that any of the differential pairs of transistors becomes saturated.

4. An integrated circuit according to Claim 3, wherein the limiting means comprise a Schottky diode (D1) connected in parallel to a resistor (R3) between the control electrode and the voltage supply terminal.

5. An integrated circuit according to any one of the Claims 1 to 4 wherein the main current channel of the reference transistor (Q3) is coupled to the voltage supply terminal via a first resistor (R2), a first node between the main current channels of the reference transistor and the first resistor forming a first output of the single ended input logic gate.

6. An integrated circuit according to Claim 5 wherein the main current channels of the input transistors (Q1, Q2) are coupled to the voltage supply terminal via a second resistor (R1), a second node between the main current channels of the input transistors (Q1, Q2) and the second resistor (R1) forming a second output of the single ended input logic gate, the first and second output forming the differential pair of inputs of a further single ended input logic gate circuit with further differential amplifiers connected thereto according to any one of the Claims 1 to 5.

7. An integrated circuit according to any one of the Claims 1 to 6, the transistors being bipolar transistors.

## Patentansprüche

1. Integrierte Logikschaltung mit Differenzpaaren von Eingängen zum Liefern komplementärer Signale (A,_A), (B,_B), wobei die Schaltung umfasst
- ein Gatter mit einseitigem Eingang, das umfasst
- eine Stromquelle (I1);
- zumindest zwei Eingangstransistoren (Q1, Q2), von denen jeder eine Steuerelektrode hat, die mit einem Logikeingang jeweils eines (A, B) der Paare von Eingängen gekoppelt sind,
- einen Bezugstransistor (Q3), wobei Hauptstromkanäle des Bezugstransistors und des Eingangstransistors parallel zueinander zwischen die Stromquelle und eine Spannungsversorgungsklemme geschaltet sind;
wobei die Schaltung eine Logikkombinationsschaltung (I2, I3, Q4, Q5, Q6, Q7, R3, D1) umfasst, die mit einer Steuerelektrode des Bezugstransistors (Q3) gekoppelt ist, zum Generieren von Spannungspegeländerungen, die einem logischen NOR von Signalen (A, B) an den Logikeingängen der jeweiligen Paare von Eingängen entsprechen und zum Liefern der genannten Logikpegeländerungen an die Steuerelektrode des Bezugstransistors (Q3);
dadurch gekennzeichnet, dass die Logikkombinationsschaltung Differenzverstärker (I2, Q4, Q5), (I3, Q6, Q7) umfasst, wobei jedes Differenzpaar von Eingängen ((A,_A)(B,_B)) mit jeweils einem der Verstärker (I2, Q4, Q5), (I3, Q6, Q7) gekoppelt ist, wobei Ausgänge der Differenzverstärker (I2, Q4, Q5), (I3, Q6, Q7) miteinander gekoppelt sind, um die genannten Spannungspegeländerungen zu bilden.

2. Integrierte Logikschaltung nach Anspruch 1 oder 2, dadurch gekennzeichnet, dass die Differenzverstärker (I2, Q4, Q5), (I3, Q6, Q7) ein Differenzpaar von Transistoren (Q4, Q5, Q6, Q7) mit durchverbundenen ersten Hauptelektroden umfassen, wobei die Eingangsanschlüsse des Differenzpaares von Eingangsanschlüssen mit Steuerelektroden jeweiliger Transistoren des Differenzpaares von Transistoren (Q4, Q5, Q6, Q7) gekoppelt sind, wobei eine zweite Hauptelektrode des Transistors (Q5, Q7) des Differenzpaares von Transistoren, die mit dem Eingang (A, B) des Logikgatters mit einseitigem Eingang gekoppelt ist, mit der Steuerelektrode des Bezugstransistors (Q3) gekoppelt ist.

3. Integrierte Logikschaltung nach Anspruch 2, dadurch gekennzeichnet, dass sie Begrenzungsmittel (D1, R3) umfasst, die mit der Steuerelektrode des Bezugstransistors (Q3) verbunden sind, zum Begrenzen eines Betrages der Änderung des Spannungspegels an der genannten Steuerelektrode, um zu verhindern, dass eines der Differenzpaare von Transistoren gesättigt wird.

4. Integrierte Schaltung nach Anspruch 3, wobei die Begrenzungsmittel eine Schottky-Diode (D1) umfassen, die parallel zu einem Widerstand (R3) zwischen die Steuerelektrode und die Spannungsversorgungsklemme geschaltet ist.

5. Integrierte Schaltung nach einem der Ansprüche 1 bis 4, wobei der Hauptstromkanal des Bezugstransistors (Q3) mit der Spannungsversorgungsklemme über einen ersten Widerstand (R2) gekoppelt ist, wobei ein ersten Knotenpunkt zwischen dem Hauptstromkanal des Bezugstransistors und dem ersten Widerstand einen ersten Ausgang des Logikgatters mit einseitigem Eingang bildet.

6. Integrierte Schaltung nach Anspruch 5, wobei die Hauptstromkanäle der Eingangstransistoren (Ql, Q2) mit der Spannungsversorgungsklemme über einen zweiten Widerstand (R1) gekoppelt sind, wobei ein zweiter Knotenpunkt zwischen den Hauptstromkanälen der Eingangstransistoren (Q1, Q2) und dem zweiten Widerstand (R1) einen zweiten Ausgang des Logikgatters mit einseitigem Eingang bildet, wobei der erste und zweite Ausgang das Differenzpaar von Eingängen einer weiteren Logikgatterschaltung mit einseitigem Eingang mit weiteren Differenzverstärkern bilden, die nach einem der Ansprüche 1 bis 5 damit verbunden ist.

7. Integrierte Schaltung nach einem der Ansprüche 1 bis 6, wobei die Transistoren Bipolartransistoren sind.

## Revendications

1. Circuit logique intégré avec des paires différentielles d'entrées pour transmettre des signaux complémentaires ((A,_A), (B,_B)), le circuit comportant
- une porte logique à entrée unique comportant
- une source de courant (I1);
- au moins deux transistors d'entrée (Q1, Q2), chacun ayant une électrode de commande couplée à une entrée logique en provenance d'une paire respective (A, B) des paires d'entrées;
- un transistor de référence (Q3), des canaux de courant principaux du transistor de référence et les transistors d'entrée étant couplés en parallèle l'un à l'autre entre la source de courant et une borne d'alimentation en tension;
le circuit comportant un circuit de combinaison logique (I2, I3, Q4, Q5, Q6, Q7, R3, Dl) couplé à une électrode de commande du transistor de référence (Q3) pour générer des changements de niveau de tension correspondant à une logique NI de signaux (A, B) à l'endroit des entrées logiques des paires respectives des paires d'entrées et délivrant lesdits changements de niveau logique à l'électrode de commande du transistor de référence (Q3);
caractérisé en ce que le circuit de combinaison logique comporte des amplificateurs différentiels (I2, Q4, Q5), (I3, Q6, Q7), chaque paire différentielle d'entrées ((A,_A), (B,_B)) étant couplée à un amplificateur respectif des amplificateurs (12, Q4, Q5), (13, Q6, Q7), des sorties des amplificateurs différentiels (I2, Q4, Q5), (13, Q6, Q7) étant couplées ensemble pour constituer lesdits changements de niveau de tension.

2. Circuit logique intégré selon la revendication 1, caractérisé en ce que les amplificateurs différentiels (12, Q4, Q5), (13, Q6, Q7) comportent une paire différentielle de transistors (Q4, Q5, Q6, Q7) avec une première électrode principale interconnectée, les connexions d'entrée de la paire différentielle de connexions d'entrée étant couplées à des électrodes de commande de transistors respectifs de la paire différentielle de transistors (Q4, Q5, Q6, Q7), une deuxième électrode principale du transistor (Q5, Q7) de la paire différentielle de transistors qui est couplée à l'entrée (A, B) de la porte logique à entrée unique étant couplée à l'électrode de commande du transistor de référence (Q3).

3. Circuit logique intégré selon la revendication 2, caractérisé en ce qu'il comporte des moyens de limitation (D1, R3) connectés à l'électrode de commande du transistor de référence (Q3) pour limiter une quantité de changement du niveau de tension à l'endroit de ladite électrode de commande de manière à éviter que l'une quelconque des paires différentielles de transistors ne soit saturée.

4. Circuit logique intégré selon la revendication 3, dans lequel les moyens de limitation comportent une diode Schottky (D1) connectée en parallèle à une résistance (R3) entre l'électrode de commande et la borne d'alimentation en tension.

5. Circuit logique intégré selon l'une quelconque des revendications précédentes 1 à 4, dans lequel le canal de courant principal du transistor de référence (Q3) est couplé à la borne d'alimentation en tension par l'intermédiaire d'une première résistance (R2), un premier noeud situé entre les canaux de courant principaux du transistor de référence et la première résistance constituant une première sortie de la porte logique à entrée unique.

6. Circuit logique intégré selon la revendication 5, dans lequel les canaux de courant principaux des transistors d'entrée (Ql, Q2) sont couplés à la borne d'alimentation en tension par l'intermédiaire d'une deuxième résistance (R1), un deuxième noeud situé entre les canaux de courant principaux des transistors d'entrée (Q1, Q2) et la deuxième résistance (R1) constituant une deuxième sortie de la porte logique à entrée unique, les première et deuxième sorties constituant la paire différentielle d'entrées d'un nouveau autre circuit de porte logique à entrée unique avec de nouveaux autres amplificateurs différentiels y étant connectés selon l'une quelconque des revendications précédentes 1 à 5.

7. Circuit logique intégré selon l'une quelconque des revendications précédentes 1 à 6, les transistors étant des transistors bipolaires.
